# EUROPEAN PATENT APPLICATION

(11) **EP 4 071 488 A1**
(43) Date of publication of application: **12.10.2022**
(21) Application number: 21167368.6
(22) Date of filing: 08.04.2021
(51) Int. Cl.: G01R 1/30, G01R 19/00, G01R 15/00, G01R 1/18, G01R 15/04, G01R 15/18, G01R 1/20

(54) **A LOW CAPACITY INTERFACE FOR SENSOR BASED MEASUREMENT OF CURRENT AND VOLTAGE IN HIGH VOLTAGE NETWORKS OR ELECTRICAL GRIDS**

(71) Applicant: ABB Schweiz AG, 5400 Baden (CH)
(72) Inventor: SEVCIK, Bretislav, 628 00 Brno (CZ); PODZEMNY, Jaromir, 621 00 Brno (CZ); SVINDRYCH, Jan, 793 56 Ryzoviste (CZ)
(74) Representative: Maiwald Patent- und Rechtsanwaltsgesellschaft mbH

(57) **Abstract**

The present invention relates to a low capacity interface (1) for sensor based measurement of current and voltage in high voltage networks or electrical grids, the interface comprising:
- an input stage (3);
- a processor stage; and
- an output stage (6, 8);
wherein the input stage is configured to connect to and receive analogue signals from a sensor (2);
wherein the processor stage comprises a first stage of protection (4), and wherein the first stage of protection comprises guard rings configured to protect against leakage current;
wherein the output stage is configured to connect to a measuring device (5).

## Description

### FIELD OF THE INVENTION

The present invention relates to a low capacity interface for sensor based measurement of current and voltage in high voltage networks or electrical grids that meets the requirements in IEC 61869.

### BACKGROUND OF THE INVENTION

The requirements contained in the last standard of IEC 61869 include a relatively strict definition of the impedances loads of measuring devices for current and voltage measuerements. At present, the impedance load of inputs for measurement of voltages and currents includes definition of resistance 2MΩ and also definition of capacitance which varies from 10pF to 50 pF. Devices with such defined parameters must be much more resistant to other intrinsic parasitic influences and must be able to ensure sufficient measuring accuracy during the changing impedances of the measured devices. Because by reducing the size of the impedance resistance from the usual value of several tens of mega ohms per unit of megaogms, the measured device (sensor) is more influenced by the measuring input itself. Also the parasitic capacitance components of the measured device have a greater influence on the accuracy of the measurement itself. Currently used measuring systems usually work with many times higher impedance and capacitance at the measuring input and thus do not meet the requirements defined by the last standard IEC 61689.

The magnitude of the output voltage is given by the design of the sensor and, especially in current sensors based on Rogowski coils, by the cross section of the winding and the number of turns; thus, the magnitude cannot be increased excessively. This may result in a growth of the internal resistance, self-inductance of the winding, and interturn capacity, all of which reduce the accuracy and affects the frequency characteristics of the sensor. Even though the nonferrous core of a sensor ensures a broad dynamical and frequency range of the measured currents, the sensitivity of the Rogowski coil depends significantly on the temperature if the core is made of common materials. Other spurious factors include location of the primary current conductor off the Rogowski coil axis, ageing of the material used for the core, and ageing of the applied sealant. The transfer of the electrical signal from the sensor and the total achievable measurement accuracy are also affected by variable input impedance of the connected postprocessing device because, considering the common Rogowski coil design, the internal electrical impedance of the coil is within the order of hundreds of Ohms to units of kiloohms (or even higher in exceptional cases); thus, the voltage drop on this impedance has to be taken into account. It clearly follows from this description that the variable input impedance of the related circuit causes a major source of possible measurement error.

Recent voltage sensors utilize impedance dividers based on capacitive or resistive elements, with major emphasis on minimizing the influence of the surrounding environment therein. However, although such effect can be markedly reduced, it cannot be completely eliminated during postprocessing; furthermore, in cases where very high measurement accuracy is required, it would be necessary (similarly as in current sensors) to know the dependencies of the output signals on the most significant spurious effects and, ideally, to monitor the operating conditions of the sensor. In this context, attention should be paid also to the actual wiring of the output electrical signal and to the input electrical parameters of the applied data acquisition circuitry for these sensors with respect to their high output impedance.

The above-outlined definition of present-day principles and structural alternatives of voltage and current sensors together with IEC 61689 requirements yields the requirement for the high accuraccy and low-capacity measuring inputs of devices for the low-voltage output signal transmitted at a higher impedance, for example typical for sensors in the ABB portfolio.

There is a need to address these issues.

### SUMMARY OF THE INVENTION

Therefore, it would be advantageous to have an improved technique for sensor based measurement of current and voltage in high voltage networks or electrical grids that meets the requirements in IEC 61869

The object of the present invention is solved with the subject matter of the independent claims, wherein further embodiments are incorporated in the dependent claims.

In an aspect, there is provided a low capacity interface for sensor based measurement of current and voltage in high voltage networks or electrical grids, the interface comprising:
- an input stage;
- a processor stage; and
- an output stage;
The input stage is configured to connect to and receive analogue signals from a sensor. The processor stage comprises a first stage of protection. The first stage of protection comprises guard rings configured to protect against leakage current. The output stage is configured to connect to a measuring device.

In an example, the guard rings comprises conductive paths connected to signal input paths.

In an example, the conductive paths of the guard rings are located on top of a printed circuit board and not covered by mask.

In an example, the processor stage comprises a second stage of protection. The second stage of protection comprises signal - line protectors.

In an example, the processor stage comprises selected amplifiers operating in voltage follower configuration.

In an example, the processor stage comprises an instrumentation amplifier.

In an example, the input stage is configured to receive analogue signals from a voltage sensor.

In an example, the input stage is configured to receive analogue signals from a voltage divider.

In an example, the input stage comprises two input channels, and one channel is configured to connect to a common ground with a ground of the sensor and not connect to a ground of the measuring device.

In an example, the input stage comprises two input channels, and one channel is configured to connect to a common ground with a ground of the sensor and with a ground of the measuring device.

In an example, the input stage is configured to receive analogue signals from a current sensor.

In an example, the input stage is configured to receive analogue signals from a Rogowski coil.

In an example, the input stage comprises two input channels and neither of the two channels has a connection to ground.

In an example, the interface is configured to operate with an input load impedance in the range of tens of kiloohms to hundreds of megaohms.

In an example, the interface is configured to operate with a parallel capacitance in the range of less than 5 picofarrads to hundreds of picofarrads.

The above aspects and examples will become apparent from and be elucidated with reference to the embodiments described hereinafter.

### BRIEF DESCRIPTION OF THE DRAWINGS

Exemplary embodiments will be described in the following with reference to the following drawing:
Fig. 1 shows an example of a low capacity interface for sensor based measurement of current and voltage in high voltage networks or electrical grids;
Fig. 2 shows an example of a low capacity interface for sensor based measurement of current and voltage in high voltage networks or electrical grids; and
Fig. 3 shows an example of a low capacity interface for sensor based measurement of current and voltage in high voltage networks or electrical grids.

### DETAILED DESCRIPTION OF EMBODIMENTS

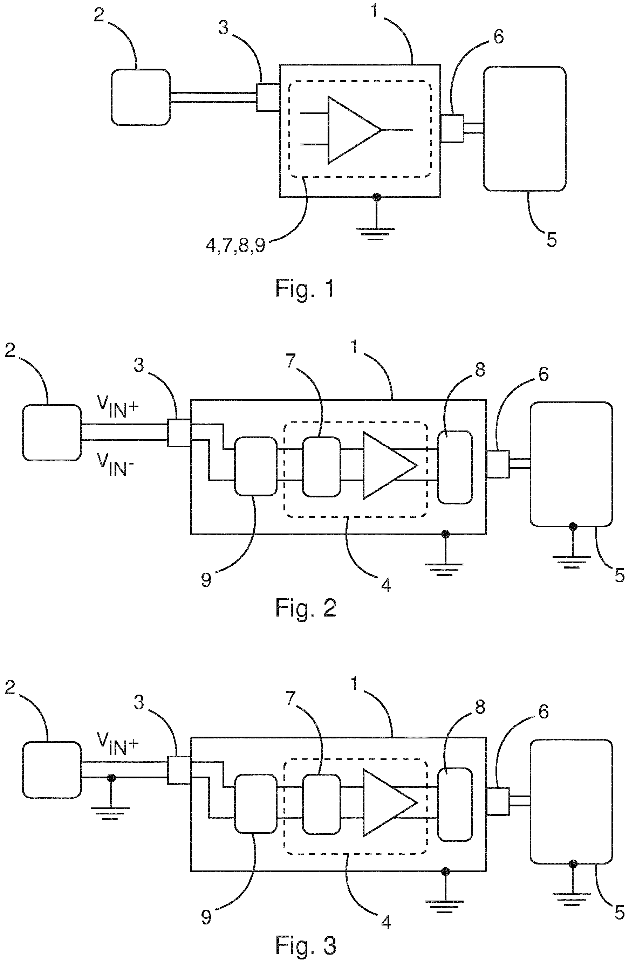

Figs. 1-3 relate to a low capacity interface for sensor based measurement of current and voltage in high voltage networks or electrical grids.

In an example the low capacity interface 1 for sensor based measurement of current and voltage in high voltage networks or electrical grids comprises an input stage 3, a processor stage, and an output stage 6, 8. The input stage is configured to connect to and receive analogue signals from a sensor 2. The processor stage comprises a first stage of protection 4. The first stage of protection comprises guard rings configured to protect against leakage current. The output stage is configured to connect to a measuring device 5.

In an example, the guard rings are configured to provide shielding against external parasitic influences.

According to an example, the guard rings comprises conductive paths connected to signal input paths.

According to an example, the conductive paths of the guard rings are located on top of a printed circuit board and not covered by mask.

According to an example, the processor stage comprises a second stage of protection 9. The second stage of protection comprises signal - line protectors.

In an example, the signal - line protectors are MAX4506 signal - line protectors.

According to an example, the processor stage comprises selected amplifiers operating in voltage follower configuration.

In an example, the selected amplifiers have a gain of unity.

In an example, the selected amplifiers are AD795 amplifiers.

According to an example, the processor stage comprises an instrumentation amplifier.

In an example, the instrumentation amplifier is an AD8229 amplifier.

According to an example, the input stage is configured to receive analogue signals from a voltage sensor.

According to an example, the input stage is configured to receive analogue signals from a voltage divider.

According to an example, the input stage comprises two input channels, and one channel is configured to connect to a common ground with a ground of the sensor and not connect to a ground of the measuring device.

Thus, the input stage is configured as pseudo-differential.

According to an example, the input stage comprises two input channels, and one channel is configured to connect to a common ground with a ground of the sensor and with a ground of the measuring device.

Thus, the input stage is configured as single mode.

According to an example, the input stage is configured to receive analogue signals from a current sensor.

According to an example, the input stage is configured to receive analogue signals from a Rogowski coil.

According to an example, the input stage comprises two input channels and neither of the two channels has a connection to ground.

Thus, the input stage has two floating input channels without any connection to ground.

Thus, the input stage is configured as differential.

According to an example, the interface is configured to operate with an input load impedance in the range of tens of kiloohms to hundreds of megaohms.

According to an example, the interface is configured to operate with a parallel capacitance in the range of less than 5 picofarrads to hundreds of picofarrads.

In an example, the input stage comprises an input channel.

In an example, the input stage comprises two input channels.

In an example, the output stage comprises an output channel

The inventors when presensred with current principles and structural alternatives of voltage and current sensors together with IEC 61689 requirements sought to develop a technique that meets the requirement for the high accuraccy and low-capacity measuring inputs of devices for the low-voltage output signal transmitted at a higher impedance

On potential way forward is a replacement of the existing measuring inputs of the device by changing the hardware by the manufacturers themselves. However, this is non-optimum and the inventors wanted to keep the sensors and measuring devices the same.

Thus, they realised that a solution could be developed that consisted of the implementation of a low-capacity interface that properly separates the signal from the sensor from the mismatched input of the measuring device and thus ensures an appropriate load for the sensor without affecting the accuracy of the measuring device.

This led to the development of the low-capacity interface for current and voltage sensor measuring with defined impedances parameters according to IEC 61689 described here. The interface allows to adjust the sensing input of a measuring device and the method to operate the same, in such, to result in a higher measuring variability with regards of various impedances loads defined in IEC 61689. The interface exceeds the requirements for impedance load defined in IEC 61689, including the circuit design ensuring the least possible influence of ambient interferences on the processing of the measured signal and thus improve the accuracy of measurement.

Continuing with the figures, the interface is described in further detail, with respect to specific embodiments.

The interface processes analog signals from current and voltage sensors based on, for example, impedance dividers and Rogowski coils. A properly matched output signal from the sensor is immediately accessible after processing at the sensor input of the original measuring device. This allows to measure the sensor output according to the requirements of IEC 61689, and the signal can be further processed by the original measuring device without mutual influence and influence of the surrounding environment. The interface can be used in current laboratories and test rooms for measuring current and voltage sensors without the need to change existing measuring equipment.

The interface described here enables the measuring current and voltage for all types of sensors, and improves the accuracy of measurement by minimizing the interfering influences that mainly affect the sensing elements of individual sensors. The parasitic effects of the sensors themselves and the change in the impedance load of the sensor do not affect the accuracy of the measurement at the sensor input of the original measuring system.

Additional information obtained during the design and individual tests of the sensors can be used, thus enabling effective correction of the measured instantaneous values of current and voltage; such correction can take into account the design and manufacturing differences between the sensors and the current operating conditions.

The technical solution enables the connection of various types of current and voltage sensors with low-voltage and high-impedance output signal. Here, a low-voltage and high-impedance signal refers to a voltage source output signal having an internal impedance in the order of hundreds of ohms to kiloohms and an output voltage amplitude in the range of tens of millivolts and volts.

Fig. 1 illustrates schematically the overall new technique of voltage and current measurement with a low-capacity interface used with existing measuring equipment.

The low-capacity interface 1 comprises input channels 3 for the processing of analog signals from the connected sensors 2, and a amplifier section with protective rings 4. The low-capacity interface 1 is hardware-configurable. In the hardware area, the unit is configurable with respect to the type and mode of connection of the sensors 2, which are always defined together with the maximum achievable measurement accuracy of a concrete sensing element. The output signal from low-capacity interface is connected to the existing measuring equipment 5 through the output channel 6.
With respect to the required measurement accuracy, practical applicability, and immunity to interferences affecting the transfer path of the measured signal, it is possible to select one of the two interface configuration enabling transmission of the measured data and connection of the applied sensor.

The basic principle is to separate the sensor signal from the measuring device. For example typical measuring devices, used in laboratories, can have input impedances ranges from tens of Mega ohms to Giga ohms. Input capacity is in hundreds of picofarads. This greatly affects the accuracy of signal processing from the sensor and does not comply with the current IEC 61869 standard for low power instrument transformers (sensors). Therefore, the inventors designed an interface that would allow to measure the output signal from the sensor without the measuring device itself distorting its output. This is achieved by active electronic based on the selected amplifiers in voltage follower configuration or by Instrumentation amplifier. The selected amplifiers are AD795 (low , noise precision fet input amplifiers , with stable Gain =1 =voltage follower configuration), the selected instrumentation Amplifier is AD8229).Thus, the sensor ouput is loaded after connection to the input of interface by appropriate impedance (for example 2 MOhms in parallel 10pF or 200Kohms in parallel 350 pF). Thus, the signal from the sensor is not affected by the load of the measuring device. For example, a interface configured for differential input, as shown in Fig. 2, can utilize two AD795 amplifiers.

Due to the very high input impedance of the amplifiers themselves, the signal from the snesor is not affected by further processing of the signal traveling through the interface. At the same time, the interface, after connection to the measuring device, transmits the signal to the input of the measuring device without distortion and the signal is thus processed correctly.

The interface has an overall design, which allows to achieve at the input of the interface strictly defined parameters by the IEC 61869 standard, especially a very low input capacity below 10 pF for voltage sensor measuring. This cannot be achieved by conventional methods or by simply selecting suitable amplifiers.

Therefore, the new interface uses two-stage protection against undesirable phenomena, such as parasitic effects of capacitances and related parasitic currents. The first stage of protection again leakage currents is based on protective rings (this is shown as the protective ring 4 of Fig. 1) or known as guard rings. These are additional gold paths on the top of the printed circuit board, which are not covered by the mask like other conductive paths. Their convenient location and connection to signal input paths eliminates leakage currents and maintains very high signal processing accuracy with extremely low input capacity. Additional guard rings provide additional shielding against external parasitic influences, which can be associated with the AD795 amplifiers.

Fig. 2 presents a variant for connecting to a current sensor, with the internal block structure shown of a low-capacity interface including the representation of the individual functional blocks in these units.

In the first variant, Fig. 3, the input channel 3 of the low-capacity interface 1 can be configured as differential; the purpose of this module is to process the signals from the current sensors. Through the input channel 3 the measured signal is routed to the protective circuit 9 (protects of sensitive JFET input of amplifier section). Then the signal is processed at the input stage 7 of amplifier section 4. Low impedance output stage 8 allows to connect signal to the existing measuring device 5 through the output channel. The described configuration can be based on the precondition of insignificant ambient disturbances and only a small temperature difference, up to 5°C, between the sensor and the low-capacitance interface.

Fig. 3 presents a variant for connecting to a voltage sensor, with the internal block structure shown of a low-capacity interface including the representation of the individual functional blocks in these units.

In the second variant, Fig. 3, the input channel 3 of the low-capacity interface 1 can be configured as pseudo-differential or single-ended. The purpose of this module is to process the signals from the voltage sensors and minimize the effects of ground potential differences (ground loops) between the signal source and the device, which leads to more accurate measurements.The described configuration is also based on the precondition of insignificant ambient disturbances and only a small temperature difference, up to 5°C, between the sensor and the low-capacitance interface.

All the above-described variants, Figs. 2 and 3, are connected between the sensor and existing measuring device via metallic wires transferring the sensor output signals in the analog form. The described technical solution comprising the above-outlined individual components improves the immunity of the transmission system between the actual sensor and the low-capacity interface against ambient interference and the compensation of spurious effects acting on the sensing element.

To achieve extremely low input channel capacity (<5 pF), the designed interface includes protective rings, which also contribute to higher circuit stability and resistance to leakage currents, which impair measurement accuracy. Thus, the parasitic effect of connected measured sensors is sufficiently minimized in a wide range of changing impedance loads.

A first stage of protection, as discussed above, is in the form of the protective rings or guards shown schematically as box 4 in Fig. 1.

A second stage of protection (shown schematically as the protective circuit 9 of Figs. 2 and 3) is based on the use of signal - line protectors from MAX 4506 for overvoltage protection and protection before transients. As mentioned above, this protection can be combined with the entire interface design, and therefore a combination of protective rings is used here as well.

The interface can be configured in differens variants according to the requirements for the input impedance and the type of measuring device to which it is connected. Thus, the interface can be configured based on configuration of inputs impedances of interface. For example, the input of interface can have the following configurations: 2Mohms in parallel with ≤10 pF, 2Mohms in parallel with ≤50 pF, 200kOhms in parallel with 350 pF. Other configuratiions are possible.

The inputs of the interface can be used in differential mode, single-ended mode or pseudodifferential mode.

Differential mode means that the inputs of interface are floating without any connections to ground (used for current sensor measuring (for example 2Mohms in parallel with ≤50 pF) at ZERA and PXI - difference between the two input voltages (V1 - V2) x Gain).

The single ended mode means that one input of interface is grounded together with common ground (ground of sensor, ground of interface and also ground of measuring device), used for voltage sensor measuring (for example 2Mohms in parallel with ≤10 pF) at system ZERA and PXI.

The pseudodifferential mode means that ground of sensor and ground of interface is separed from ground of measuring device Thus the one input of interface is grounded together with sensor ground but the ground of measuring device is connected through ground referencing resistor. This configuration is used for measuring Voltage sensors for impedance load 200kOhms in parallel with 350 pF because due to the low resistance there is a higher risk of ground loops. In this configuration an instrumentation amplifier AD8229 is used.

It was discussed above that the interfeace can be configured in different hardware configurations. Here, hardware configurations means that the board can be equipped with jumper switches and the input impedance can be set according to requirements.

Thus, the inventors developed a hardware-configurable low-capacity interface enabling sensor measurement of current and voltage in high voltage networks or electrical grids operating with different voltage levels and impedances loads according to the new requirements related in IEC 61869. In order to ensure extremely low capacitance of input channels, signal stability and higher immunity of such systems to ambient disturbancy and to improve the measurement accuracy the interface contains driven guard rings. Thus, the differential or pseudo-differential input or single-mode channel configurations can be used without loss of signal stability.

## Claims

1. A low capacity interface (1) for sensor based measurement of current and voltage in high voltage networks or electrical grids, the interface comprising:
- an input stage (3);
- a processor stage; and
- an output stage (6, 8);
wherein the input stage is configured to connect to and receive analogue signals from a sensor (2);
wherein the processor stage comprises a first stage of protection (4), and wherein the first stage of protection comprises guard rings configured to protect against leakage current;
wherein the output stage is configured to connect to a measuring device (5).

2. Interface according to claim 1, wherein the guard rings comprises conductive paths connected to signal input paths.

3. Interface according to claim 2, wherein the conductive paths of the guard rings are located on top of a printed circuit board and not covered by mask.

4. Interface according to any of claims 1-3, wherein the processor stage comprises a second stage of protection (9), and wherein the second stage of protection comprises signal - line protectors.

5. Interface according to any of claims 1-4, wherein the processor stage comprises selected amplifiers operating in voltage follower configuration.

6. Interface according to any of claims 1-4, wherein the processor stage comprises an instrumentation amplifier.

7. Interface according to any of claims 1-6, wherein the input stage is configured to receive analogue signals from a voltage sensor.

8. Interface according to claim 7, wherein the input stage is configured to receive analogue signals from a voltage divider.

9. Interface according to any of claims 7-8, wherein the input stage comprises two input channels, and wherein one channel is configured to connect to a common ground with a ground of the sensor and not connect to a ground of the measuring device.

10. Interface according to any of claims 7-8, wherein the input stage comprises two input channels, and wherein one channel is configured to connect to a common ground with a ground of the sensor and with a ground of the measuring device.

11. Interface according to any of claims 1-6, wherein the input stage is configured to receive analogue signals from a current sensor.

12. Interface according to claim 11, wherein the input stage is configured to receive analogue signals from a Rogowski coil.

13. Interface according to any of claims 11-12, wherein the input stage comprises two input channels and neither of the two channels has a connection to ground.

14. Interface according to any of claims 1-13, wherein the interface is configured to operate with an input load impedance in the range of tens of kiloohms to hundreds of megaohms.

15. Interface according to claim 14, wherein the interface is configured to operate with a parallel capacitance in the range of less than 5 picofarads to hundreds of picofarads.
